Europäisches Patentamt

European Patent Office

Office européen des brevets

(11) Publication number: **0 085 395**
**A2**

(12) **EUROPEAN PATENT APPLICATION**

(21) Application number: **83100721.6**

(22) Date of filing: **26.01.83**

(51) Int. Cl.³: **H 01 L 27/10**

(30) Priority: **28.01.82 US 343412**

(43) Date of publication of application:
**10.08.83 Bulletin 83/32**

(84) Designated Contracting States:
**BE DE FR IT**

(71) Applicant: **Western Electric Company, Incorporated**
**222 Broadway**
**New York, NY 10038(US)**

(72) Inventor: **McPartland, Richard Joseph**
**683 Lexington Road**
**Nazareth Pennsylvania 18064(US)**

(72) Inventor: **Rosenzweig, Walter**
**1407 Stoneridge Road**
**Allentown Pennsylvania 18104(US)**

(72) Inventor: **Yanof, Arnold William**
**1907 Homestead Avenue**
**Bethlehem Pennsylvania 18018(US)**

(74) Representative: **Blumbach Weser Bergen Kramer**
**Zwirner Hoffmann Patentanwälte**
**Radeckestrasse 43**
**D-8000 München 60(DE)**

(54) **High density memory cell.**

(57) Memory cell spacing can be reduced by using the diffused capacitance enhancement layer (22) of a so-called hi-C cell as the isolating element between adjacent charge storage regions. This allows elimination of the field oxide (21) normally used for this function. Elimination of the field oxide permits closer packing of the cells.

FIG-4F

EP 0 085 395 A2

Croydon Printing Company Ltd

## HIGH DENSITY MEMORY CELL

High capacity, low cost computers rely on very large scale integrated semiconductor information storage devices (e.g. semiconductor memories). Semiconductor memories comprise many storage cells interconnected by conductors insulated from the underlying semiconductor by a field oxide layer, i.e., a layer sufficiently thick to prevent electric coupling between the conductor and the semiconductor. Each cell stores information in the form of electrical charge. The amount of charge that is used to represent the information, typically a "1" or "0", is a function of various parameters, but is directly dependent on the area occupied by a storage cell on the semiconductor chip. As the area diminishes to meet the goals of modern circuit designers, the amount of charge representing a bit of information decreases to the point where it is difficult for the sense amplifier to detect. Thus techniques to increase the charge storage capacity of a given area of semiconductor have become vital to the continued design progress of electronic information processing hardware.

Most contemporary dynamic random access memory (DRAM) designs rely on charge coupled storage elements. Charge is gated into these storage elements from a gate controlled source in the fashion of insulated gate field effect transistors (IGFET). The charge coupled storage element is an MOS capacitor as in a CCD (charge coupled device). In a typical storage element, the capacitance per unit area has a depletion layer component that is limited by the impurity level of the substrate. Ignoring gate threshold modifying implants, that impurity level is the same as it is in the gate region of the device, and the latter needs to be moderate in order to obtain appropriately low column and other parasitic capacitances.

It has been recognized that the impurity levels in these two regions do not have to be the same. By the addition of selective impurity implantation steps, the doping level of the substrate underlying the charge storage region can be increased, and the charge storage capacity increased, independent of the doping level under the gate. The use of this "capacitance enhancement layer" has been adopted in DRAM device designs (see e.g., U. S. Patent No. 4,112,575), and very likely has other applications yet to be realized.

It is important to reduce as much as possible the semiconductor area required by each storage cell, and it is this problem to which Applicant's invention is primarily directed.

Applicant has now recognized that the capacitance enhancement layer can be utilized for two additional roles: as a channel stop between devices, and as an added filter capacitance. Applicant has also recognized that selective utilization of the capacitance enhancement layer in this fashion allows portions of the field insulator to be eliminated. In a well designed DRAM, nearly all of the field insulator is utilized for separation between devices. Elimination of a significant part of the field insulator following the techniques to be described allows for closer packing of devices and the realization of the many advantages of miniaturization.

An additional advantage of Applicant's new isolation scheme is to increase the capacitance between the storage capacitor counter-electrode (field plate) and the substrate. This results from reducing the insulator thickness in the isolation region from the conventional thick oxide of $\approx$10,000Å, to the thin oxide of $\approx$250Å. The increase in this capacitance is highly desirable in devices which utilize on-chip substrate bias generators. In such devices, the substrate essentially floats and experiences voltage bumps as a result of capacitive coupling from active circuit nodes. These voltage bumps are coupled back to other portions of the circuitry and can result in undesirable noise. This capacitance to any stable nodes, such as the field plate helps to filter such voltage bumps
and thereby reduce noise.

In the drawing:

FIG. 1 is a schematic plan view of a typical DRAM
multicell layout with capacitor enhancement implants.

FIG. 2 is a section view through 2A-2A of FIG. 1
showing in particular the completed field insulator of a
typical prior art device.

FIG. 2B is a sectional view through 2B-2B of
FIG. 1.

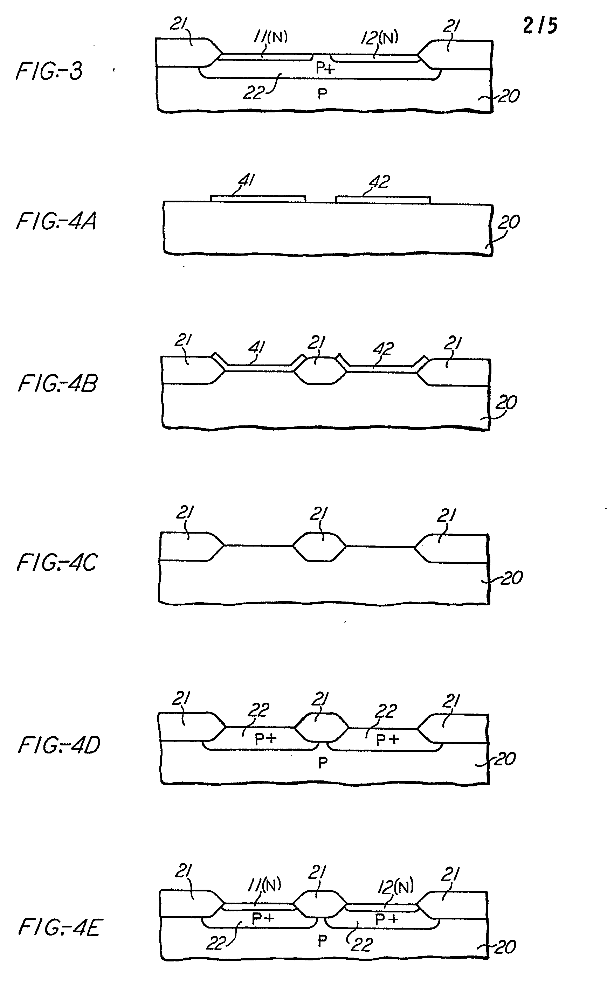

FIG. 3 is a sectional view similar to that of

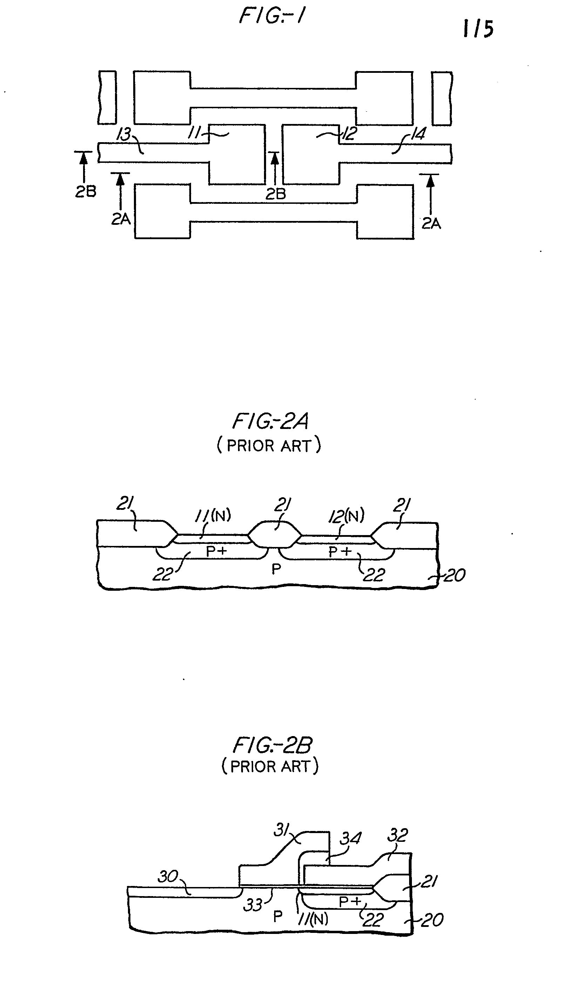

FIG. 2A showing the completed field insulator structure
according to the invention.

FIGS. 4A to 4E are sectional views showing a
sequence of typical processing steps used to form the prior
art device of FIG. 2.

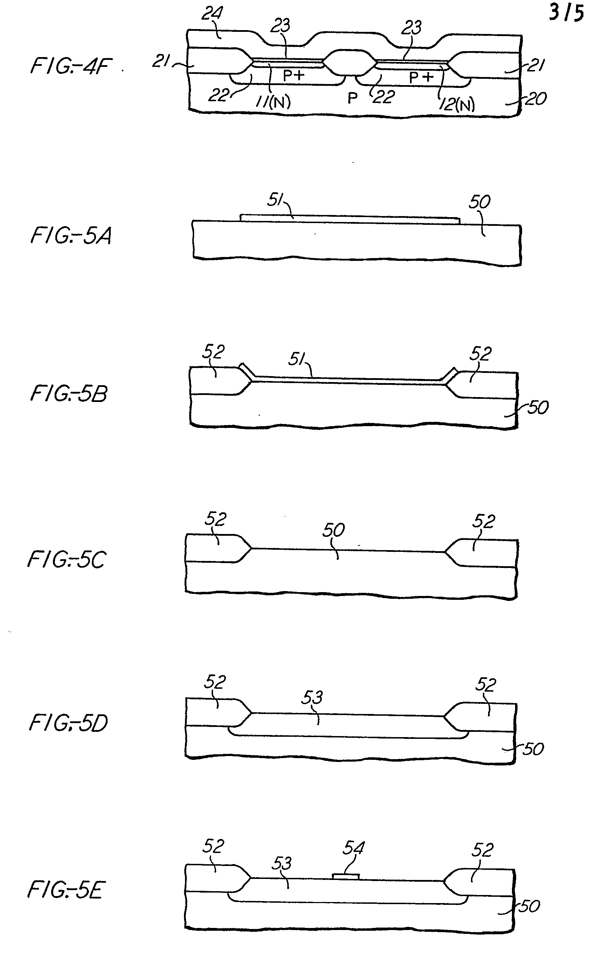

FIGS. 5A to 5H are sectional views similar to
those of FIGS. 4A to 4E showing a typical series of
processing steps useful for forming the structure of
FIG. 3.

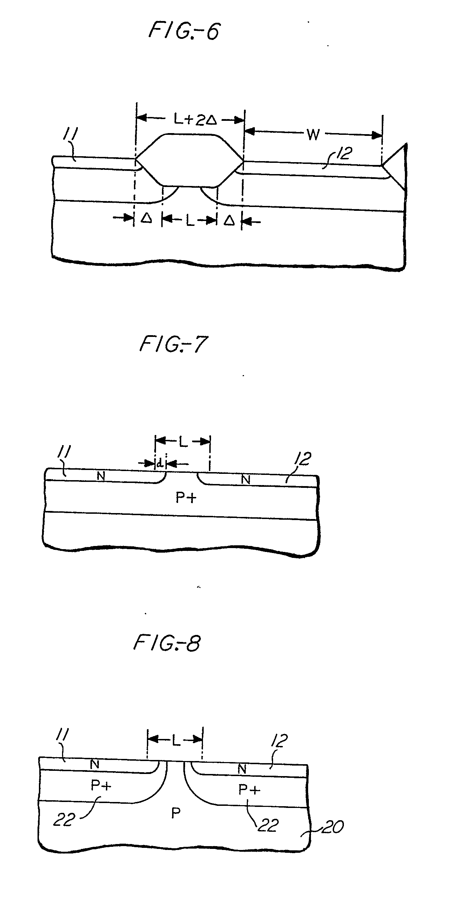

FIG. 6 is an expanded view showing in greater
detail the middle portion of the field insulator shown in
FIG. 2.

FIG. 7 is an expanded view showing in greater
detail the middle portion of the field insulator shown in
FIG. 3.

FIG. 8 is an alternate configuration to FIG. 7
differing only in the P+ implant.

FIG. 1 illustrates one of many possible multicell
arrangements that can be adapted to take advantage of the
invention described. The characteristic common to all such
multicell designs is a close packed geometry. In the
design shown, numerals 11 and 12 denote the locations of
charge storage capacitors of adjacent pairs of devices.
The charge transfer regions, containing the charge input or
source and the gate regions are at 13 and 14 respectively.
Typically these comprise a common source and two gates.

The details of these regions, and the metallization connected to these regions, as well as the electrodes for the charge storage elements 11 and 12 have been omitted primarily for clarity, but also because the specific details of these elements are not part of the invention. That is, various alternative layouts and metallization arrangements can be used while still realizing the benefits of the invention. The elements that are most relevant to a discussion of the invention are shown in FIG. 2. Here the substrate 20 is shown with selectively grown field insulators, typically an oxide, 21, the capacitance enhancement layer 22, and the two closely spaced charge storage elements 11 and 12. These are shown as p, p+ and n layers as would be typical of n-channel devices. However, the complementary configuration can be used as well.

The gate and source 13 associated with storage element 11, is shown in FIG. 2B. Many configurations are possible for those elements and the one shown, probably the most typical, is shown as exemplary only. It illustrates a source region 30, which here is a diffused bit line, gate 31 and memory field plate 32, with the latter two elements overlying the conventional dielectric layer 33. This drawing, in contrast to FIG. 2A, includes the metallization. The capacitance enhancement layer 22 and the storage layer 11 are essentially as they appear in FIG. 2A. FIG. 3, in contrast to FIG. 2A, illustrates the formation of adjacent storage elements without an intervening field oxide or field insulator, in accordance with the invention. A discussion of the different process sequences for the Fig. 2 and Fig. 3 structures will further illustrate the invention.

A typical processing sequence for forming the Fig. 2 structure is shown in FIGS. 4A to 4E. From a processing point of view, each of these steps taken individually is conventional and need not be described in detail in order for those skilled in the art to practice the invention.

FIG. 4A shows substrate 20, usually silicon, having masking portions 41 and 42 formed on the surface as shown to delineate subsequently formed thick oxide regions. The selective process for forming these regions is widely used in various alternative forms. Typically it involves depositing or growing a mask layer, typically silicon nitride, and photolithographically patterning the layer to produce the structure shown in FIG. 4A. The structure is then oxidized to produce the field oxide 21 as shown in FIG. 4B. The edges of the oxide form familiar "birds beak" configuration at the edges of the nitride masking layer. The nitride mask layer is removed as shown in FIG. 4C. Impurities are then introduced into the exposed portions of substrate 20 to form the capacitance enhancement layer 22 (FIG. 4D) and impurities of the opposite conductivity type are introduced to form layers 11 and 12 within the boundaries of the capacitance enhancement layer 22. Methods for forming the impurity layers are well known and include for example ion diffusion, i.e., pre-deposit from a glass layer or a vapor and drive in by thermal processing, or pre-deposit by ion implantation and drive-in by thermal processing. The shallow layer can also be formed by implantation of ions directly to the depth desired. The pre-deposits can be done separately, or simultaneously. In the latter case, the deep lying impurities can be chosen of a species (e.g. boron) that diffuses more rapidly than those of the surface layer (e.g. arsenic) and the two distinct layers created during the thermal drive-in step.

FIGS. 4D and 4E show these two diffused layers formed separately. The capacitance enhancement layer is shown at 22 in these figures and the shallower n layer is shown at 11 and 12 in FIG. 4E. The impurity levels of these layers and the substrate depend on a variety of design choices. If the electrical potential used to bias the memory plate overlying these storage regions is to be at a relatively high voltage, then inversion of the surface of the storage region will occur without any n-doped surface layer, or a lightly-doped one. On the other hand, if the memory cell is designed with the memory plate at or near ground potential, the n-doped surface layer becomes desirable. Typical impurity levels for this layer are $10^{18}/cm^3$. Typical depths of this layer are 0.2μm. Typical impurity levels for layer 22 are $10^{17}/cm^3$ and typical depths are 1μm. Substrate impurity concentrations are conventionally of the order of $10^{15}/cm^3$.

FIG. 4F shows the completed structure with the inclusion of storage capacitor dielectric 23 and the storage capacitor field plate 24. As is typical in this device, a field plate common to the two storage layers (11 and 12) is used.

A typical processing sequence according to the invention is shown in FIGS. 5A-5G. This is but one of many possible routes to attain the reduced cell size according to the principles of the invention. The field oxide for the structure is produced in a manner similar to that used in FIGS. 4A and 4B except that the nitride layer 51 in FIG. 5A is continuous and the intermediate oxide portion 21 of FIG. 4B is eliminated. Thus, as shown in FIG. 5B, a structure is produced with field oxide 52 bounding the region to be occupied by two memory plates but without any field oxide between the memory plates. In FIG. 5C, the nitride layer 51, used to define the regions in which field oxide is grown, is shown removed. Techniques and process parameters for the deposition of the nitride mask layer 51, the growth of field oxide 52, the removal of the nitride mask, etc. as well as the other operations to be described, are so well known that recital here is not needed.

FIG. 5D shows the formation of the capacitace enhancement layer 53. In the context of the invention, it is useful to have this layer extended continuously, i.e., without the interruption caused by the presence of field oxide as seen in FIG. 4D. In this manner, the capacitance enhancement layer acts to prevent depletion and inversion of the region between storage regions so as to prevent conduction between such regions. A continuous layer is not essential, for reasons that will become evident, but has useful isolating characteristics. FIG. 5E shows a mask feature 54 selectively formed by conventional means, i.e., photo, electron beam, ion beam or other appropriate lithographic or mask-forming procedure.

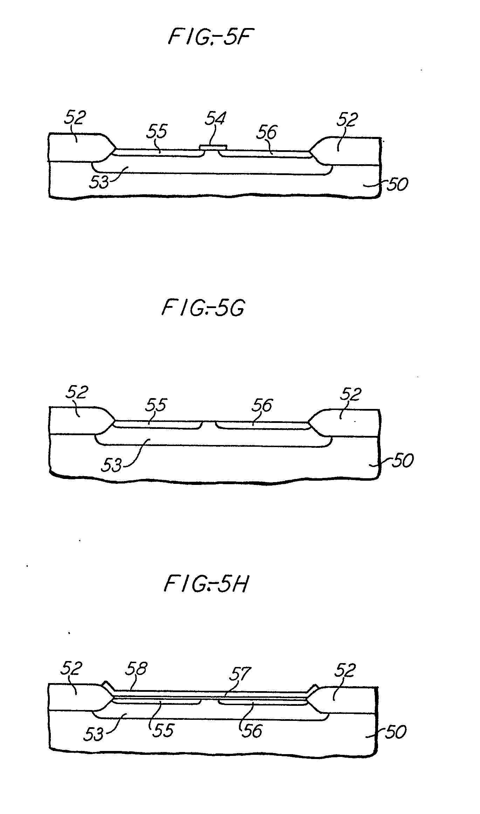

FIG. 5F shows formation of the n-surface layers for the two storage regions 55 and 56 respectively. FIG. 5G shows the mask 54 removed. FIG. 5H shows the completed MOS capacitors, i.e., insulator 57 and the memory field plates 58 and 59 for the two storage elements, respectively, of devices 11 and 12 (FIG. 1).

The reduction in the area occupied by two adjacent devices made possible by the use of the invention can be appreciated from FIGS. 6 and 7.

FIG. 6 illustrates the minimum separation between storage regions 11 and 12 that can be obtained with a field oxide separating the regions. The length L is the minimum linewidth that a given processing and lithographic technology is capable of producing with reliability and high yield. The increments denoted by $\Delta$ represent the unavoidable increase in that lateral dimension as a consequence of the genetic or native growth mechanism to the required field oxide thickness. That growth mechanism, in current technology is an oxidation mechanism although growth of nitride layers is a potential alternative. The nature of the oxide growth is such that it occurs laterally as well as transverse to the silicon surface. The lateral growth may be nearly equal to the vertical growth. A stripe of one micron thick isolating field oxide that is for example lithographically defined to be two microns wide ends up nearly four microns wide. If the width W of the storage region is of the order of a few microns the "encroachment" on this region, represented by $\Delta$, is of the order of 1 micron, resulting in a significant loss of storage capacity. This analysis, so far, is two dimensional. If the other portions of the perimeter of the storage regions (11 and 12) are considered the storage area susceptible to "recapture", using the techniques of the invention, are even greater. It will be evident to those skilled in the art, that the usual approach to forming the field insulator is to first mask the silicon surface with a mask layer composed of an insulator of a different material, typically silicon nitride, then open windows in the mask layer where the field insulator is desired, and finally to grow the field insulator in those windows by a well established growth technique. The length L in this case is the dimension of the window formed in the nitride mask layer.

FIG. 7 illustrates the advantage of eliminating the field insulator according to the invention. The separation between storage regions is equivalent to L-2d, which is the intended design separation. d corresponds to the lateral diffusion of the implanted impurity 55 and 56 under the mask 54.

An alternative way to produce a structure that is nearly equivalent to that of FIG. 7 is evident from the structure shown in FIG. 8. Here the capacitance enhancement layer is not continuous between charge storage regions 11 and 12. The structure is made by applying mask 54 (FIG. 5E) prior to the formation of the capacitance enhancement layer (FIG. 5C). It may be advantageous to use a separate mask (with a width smaller than the width of mask 54) to form this layer thus ensuring that the charge storage layer is clearly bounded, where desired, by the charge enhancement layer.

An examination of FIGS. 6-8 reveals a further benefit of the invention. The lateral diffusion of the storage layers 11 and 12 contribute to the effective storage areas in the configurations shown in FIGS. 7 and 8. In FIG. 6, the presence of the isolating oxide region prevents significant lateral movement of the impurity layers 11 and 12.

Various additional modifications and extensions of this invention will become apparent to those skilled in the art. All such variations and deviations which basically rely on the teachings through which this invention has advanced the art are properly considered to be within the spirit and scope of this invention.

Claims

1. A semiconductor device comprising an array of closely packed storage cells (e.g. 30, 31, 22) each cell including a storage element which comprises a conductor (e.g. 58) insulated from a semiconductor storage region (e.g. 55, 53), said array further including regions of field insulator (e.g. 52) separating adjacent storage cells,

CHARACTERIZED IN THAT

closely adjacent storage elements of different storage cells share a common conductor (e.g. 58), each storage element comprising a shallow region (e.g. 55, 56) of one conductivity type and an underlying heavily doped region (e.g. 53) of the opposite conductivity type, the portion of the array between the adjacent storage regions and underlying the common conductor being devoid of field insulator.

2. The device of claim 1
FURTHER CHARACTERIZED IN THAT
the conductor comprises polysilicon.

3. The device of claim 1
FURTHER CHARACTERIZED IN THAT
the conductor comprises a metal silicide.

4. The device of claim 1
FURTHER CHARACTERIZED IN THAT
the insulating material is silicon dioxide.

5. The device of claim 1
FURTHER CHARACTERIZED IN THAT
the heavily doped region (e.g. 22) is a capacitance enhancement layer contained in a semiconductor body (e.g. 20) of the same conductivity type but of lighter doping.

6. The device of claim 5
FURTHER CHARACTERIZED IN THAT
the distance corresponding to the region separating storage regions of adjacent cells is less than 3 microns.

- 11-

0085395

7. The device of claim 6

FURTHER CHARACTERIZED IN THAT

a single continuous capacitance enhancement layer is common to at least two storage elements.

8. The device of claim 1

FURTHER CHARACTERIZED IN THAT

a separate capacitance enhancement layer (e.g. Fig. 8) is provided for each storage element.

9. The device of claim 1

FURTHER CHARACTERIZED IN THAT

a source region (e.g. 30) of the same conductivity type as that of the shallow layer of the storage region, spaced from the shallow layer by a channel (e.g. 33) having the opposite conductivity type, and a gate (e.g. 31) overlying the channel so that, with appropriate voltage applied to the gate, charge is transferred from the source to the storage region.

0085395

1/5

## FIG.-1

## FIG.-2A
(PRIOR ART)

## FIG.-2B
(PRIOR ART)

0085395

215

FIG.-3

11(N)    12(N)
21         P+         21
22    P              20

FIG.-4A

41              42
20

FIG.-4B

21    41    21    42    21
20

FIG.-4C

21         21         21
20

FIG.-4D

21    22    21    22    21
P+         P+
P              20

FIG.-4E

21    11(N)    21    12(N)    21
P+              P+
22    P    22    20

FIG.-4F

FIG.-5A

FIG.-5B

FIG.-5C

FIG.-5D

FIG.-5E

0085395

4/5

FIG.-5F

FIG.-5G

FIG.-5H

5/5

FIG.-6

FIG.-7

FIG.-8